# EUROPEAN PATENT APPLICATION

(11) **EP 4 625 174 A1**
(43) Date of publication of application: **01.10.2025**
(21) Application number: 25163258.4
(22) Date of filing: 12.03.2025
(51) Int. Cl.: G06F 11/07, G06F 11/18, G01R 31/317, H03K 5/19, G06F 11/16

(54) **PROCESSING SYSTEM, RELATED INTEGRATED CIRCUIT, DEVICE AND METHOD**

(30) Priority: 28.03.2024 IT 202400007039
(71) Applicant: STMicroelectronics International N.V., 1228 Plan-les-Ouates, Geneva (CH)
(72) Inventor: COLOMBO, Roberto, D-81829 München (DE); VIKAS, Amit, Greater noida (IN)
(74) Representative: Buzzi, Notaro & Antonielli d'Oulx S.p.A.

(57) **Abstract**

The present disclosure relates to a processing system comprising a plurality of safety monitoring circuits and a fault collection and error management circuit (120a) configured to generate one or more reaction signals as a function of error signals provided by the safety monitoring circuits. The fault collection and error management circuit (120a) comprises a sequential logic circuit supplied by a first supply voltage (VDD1) and driven by a first clock signal (OSC1).

Specifically, the fault collection and error management circuit (120a) comprises a pulse generator circuit (1206) configured to generate a trigger signal (HB) in response to the first clock signal (OSC1), wherein the pulse generator circuit (1206) is supplied by the first supply voltage (VDD1). The processing system comprises also a first monitoring circuit (1222a), a second monitoring circuit (1222b) and a combinational logic circuit (1224).

The first monitoring circuit (1222a) is configured to generate a first error signal in response to determining that a time between two consecutive triggers in the trigger signal (HB) is greater than a given first maximum time, wherein the first monitoring circuit (1222a) comprises a sequential logic circuit supplied by a second supply voltage (VDD2) and driven by a second clock signal (OSC2). The second monitoring circuit (1222b) is configured to generate a second error signal in response to determining that a time between two consecutive triggers in the trigger signal (HB) is greater than a given second maximum time, wherein the second monitoring circuit (1222b) comprises a sequential logic circuit supplied by the second supply voltage (VDD2) and driven by the second clock signal (OSC2). In response to determining that the first error signal or the second error signal is asserted, the combinational logic circuit (1224) asserts a third error signal (ERR_{HB}).

## Description

### Technical Field

Embodiments of the present disclosure relate to the error management within processing systems, such as micro-controllers.

### Background

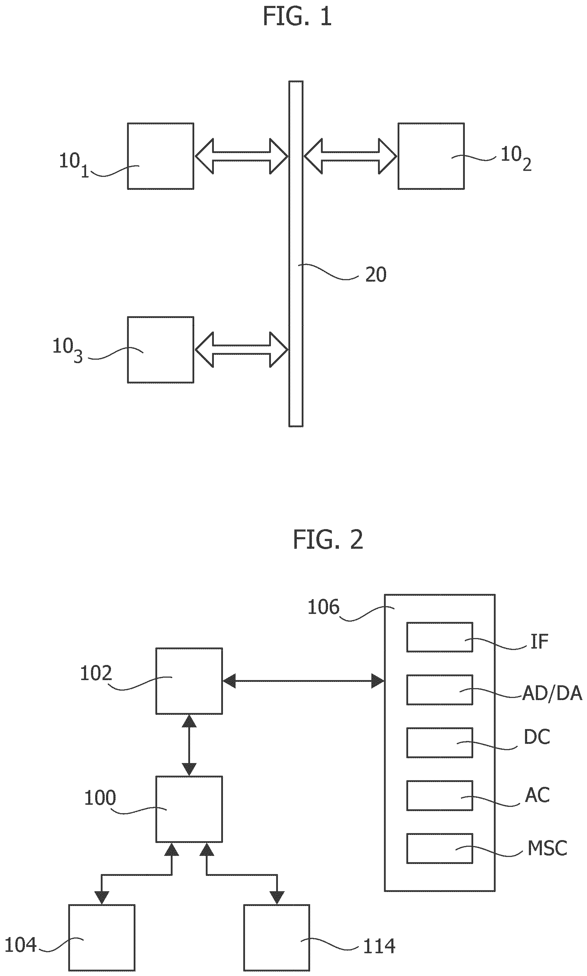

Figure 1 shows a typical electronic system, such as the electronic system of a vehicle, comprising a plurality of processing systems 10, such as embedded systems or integrated circuits, e.g., a Field Programmable Gate Array (FPGA), a Digital Signal Processor (DSP) or a micro-controller (e.g., dedicated to the automotive market).

For example, in Figure 1 are shown three processing systems 10₁, 10₂ and 10₃ connected through a suitable communication system 20. For example, the communication system may include a vehicle control bus, such as a Controller Area Network (CAN) bus, and possibly a multimedia bus, such as a Media Oriented Systems Transport (MOST) bus, connected to vehicle control bus via a gateway. Typically, the processing systems 10 are located at different positions of the vehicle and may include, e.g., an Engine Control Unit, a Transmission Control Unit (TCU), an Anti-lock Braking System (ABS), a Body Control Module (BCM), and/or a navigation and/or multimedia audio system. Accordingly, one or more of the processing systems 10 may also implement real-time control and regulation functions. These processing systems are usually identified as Electronic Control Units.

Figure 2 shows a block diagram of an exemplary digital processing system 10, such as a micro-controller, which may be used as any of the processing systems 10 of Figure 1.

In the example considered, the processing system 10 comprises a microprocessor 102, usually the Central Processing Unit (CPU), programmed via software instructions. Usually, the software executed by the microprocessor 102 is stored in a non-volatile program memory 104, such as a Flash memory or EEPROM. Thus, the memory 104 is configured to store the firmware of the processing unit 102, wherein the firmware includes the software instructions to be executed by the microprocessor 102. Generally, the non-volatile memory 104 may also be used to store other data, such as configuration data, e.g., calibration data.

The microprocessor 102 usually has associated also a volatile memory 104b, such as a Random-Access-Memory (RAM). For example, the memory 104b may be used to store temporary data.

As shown in Figure 2, usually the communication with the memories 104 and/or 104b is performed via one or more memory controllers 100. The memory controller(s) 100 may be integrated in the microprocessor 102 or connected to the microprocessor 102 via a communication channel, such as a system bus of the processing system 10. Similarly, the memories 104 and/or 104b may be integrated with the microprocessor 102 in a single integrated circuit, or the memories 104 and/or 104b may be in the form of a separate integrated circuit and connected to the microprocessor 102, e.g., via the traces of a printed circuit board.

In the example considered, the microprocessor 102 may have associated one or more (hardware) resources/peripherals 106 selected from the group of:
- one or more communication interfaces IF, e.g., for exchanging data via the communication system 20, such as a Universal asynchronous receiver/transmitter (UART), Serial Peripheral Interface Bus (SPI), Inter-Integrated Circuit (I²C), Controller Area Network (CAN) bus, and/or Ethernet interface, and/or a debug interface; and/or
- one or more analog-to-digital converters AD and/or digital-to-analog converters DA; and/or
- one or more dedicated digital components DC, such as hardware timers and/or counters, or a cryptographic co-processor; and/or
- one or more analog components AC, such as comparators, sensors, such as a temperature sensor, etc.; and/or
- one or more mixed signal components MSC, such as a PWM (Pulse-Width Modulation) driver.

Generally, a dedicated digital components DC may also correspond to a FPGA integrated in the processing system 10. For example, in this case, the memory 104 may also comprise the program data for such a FPGA.

Accordingly, the digital processing system 10 may support different functionalities. For example, the behavior of the microprocessor 102 is determined by the firmware stored in the memory 104, e.g., the software instructions to be executed by a microprocessor 102 of a micro-controller 10. Thus, by installing a different firmware, the same hardware (micro-controller) can be used for different applications.

In this respect, future generation of such processing systems 10, *e.g.,* micro-controllers adapted to be used in automotive applications, are expected to exhibit an increase in complexity, mainly due to the increasing number of requested functionalities (new protocols, new features, etc.) and to the tight constraints of execution conditions (e.g., lower power consumption, increased calculation power and speed, etc.).

For example, recently more complex multi-core processing systems 10 have been proposed. For example, such multi-core processing systems may be used to execute (in parallel) several of the processing systems 10 shown in Figure 1, such as several ECUs of a vehicle.

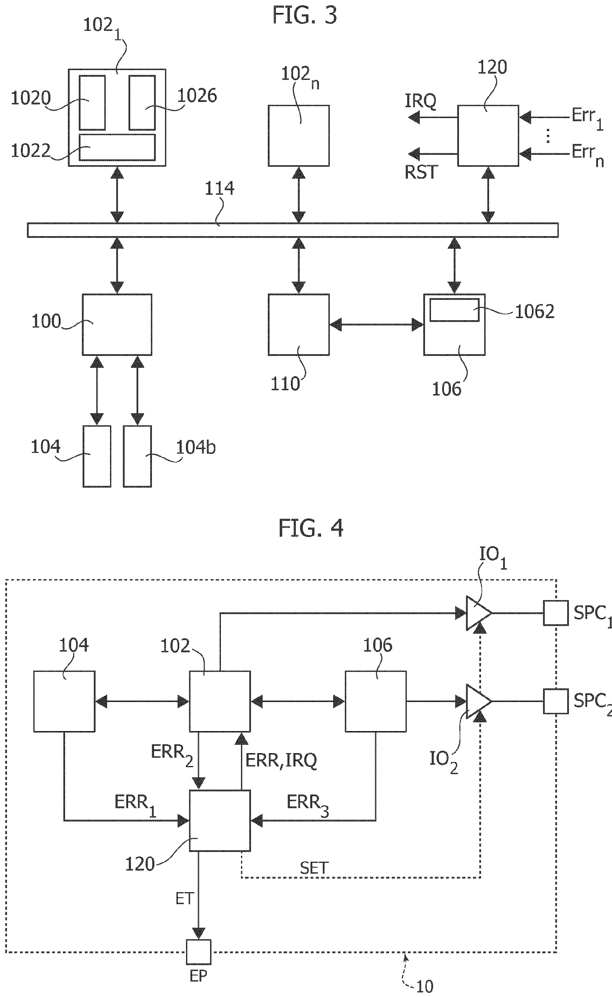

Figure 3 shows an example of a multi-core processing system 10. Specifically, in the example considered, the processing system 10 comprises a plurality of n processing cores 102₁...102ₙ connected to a (on-chip) communication system 114. For example, in the context of real-time control systems, the processing cores 102₁...102ₙ may be ARM Cortex^{®}-R52 cores. Generally, the communication system 114 may comprise one or more bus systems, e.g., based on the Advanced eXtensible Interface (AXI) bus architecture, and/or a Network-on-Chip (NoC).

For example, as shown at the example of the processing core 102₁, each processing core 102 may comprise a microprocessor 1020 and a communication interface 1022 configured to manage the communication between the microprocessor 1020 and the communication system 114. Typically, the interface 1022 is a master interface configured to forward a given (read or write) request from the microprocessor 1020 to the communication system 114, and forward an optional response from the communication system 114 to the microprocessor 1020. However, the communication interface 1022 may also comprise a slave interface. For example, in this way, a first microprocessor 1020 may send a request to a second microprocessor 1020 (via the communication interface 1022 of the first microprocessor, the communication system 114 and the communication interface 1022 of the second microprocessor).

Generally, each processing core 102₁...102ₙ may also comprise further local resources, such as one or more local memories 1026, usually identified as Tightly Coupled Memory (TCM).

As mentioned before, typically the processing cores 102₁...102ₙ are arranged to exchange data with a non-volatile memory 104 and/or a volatile memory 104b. In a multi-core processing system 10, often these memories are system memories, *i.e.,* shared for the processing cores 102₁...102ₙ. As mentioned before, each processing core 102₁...102ₙ may, however, comprise one or more additional local memories 1026.

For example, as shown in Figure 3, the processing system 10 may comprise one or more memory controllers 100 configured to connect at least one non-volatile memory 104 and at least one volatile memory 104b to the communication system 114. As mentioned before, one or more of the memories 104 and/or 104b may be integrated in the integrated circuit of the processing system 10 or connected externally to the integrated circuit.

As mentioned before, the processing system 10 may comprise one or more resources 106, such as one or more communication interfaces or co-processors (e.g., a cryptographic co-processor). The resources 106 are usually connected to the communication system 114 via a respective communication interface 1062. In general, the communication interface 1062 comprises at least a slave interface. For example, in this way, a processing core 102 may send a request to a resource 106 and the resource returns given data. Generally, one or more of the communication interfaces 1062 may also comprise a respective master interface. For example, such a master interface may be useful in case the resource has to start a communication in order to exchange data via (read and/or write) request with another circuit connected to the communication system 114, such as a resource 106 or a processing core 102. For example, for this purpose, the communication system 114 may indeed comprise an Advanced Microcontroller Bus Architecture (AMBA) High-performance Bus (AHB), and an Advanced Peripheral Bus (APB) used to connect the resources/peripherals 106 to the AMBA AHB bus.

Often such processing systems 10 comprise also one or more Direct Memory Access (DMA) controllers 110. For example, as shown in Figure 3, a DMA controller 110 may be used to directly exchange data with a memory, e.g., the memory 104b, based on requests received from a resource 106. For example, in this way, a communication interface IF may directly read data (via the DMA controller 110) from the memory 104b and transmit these data, without having to exchange further data with a processing unit 102. Generally, a DMA controller 110 may communicate with the memory or memories via the communication system 114 or via one or more dedicated communication channels.

In this respect, irrespective of the complexity of the processing system 10 (e.g., with respect to the number of processing cores 102 and/or number and type of the resources 106), a typical processing system 10 comprises also a fault collection and error management circuit 120.

For example, European patent application n. EP 3 534 261 A1 discloses possible embodiments of a fault collection and error management circuit 120, which is incorporated herein by reference for this purpose.

Specifically, as shown in Figure 4, at least one of the circuits 102, 104 and 106 may generate one or more error signals ERR₁, ..., ERRₘ. For example, such error signals ERR may be generated by at least one of:
- a memory 104 supporting an error detection and optional correction function, which generates an error signal ERR₁ when the data read from the memory 104 contain errors and/or when data could not be written to the memory;
- a processing core 102 configured to generate an error signal ERR₂ in response to a hardware and/or software failure; and
- a communication interface configured to generate an error signal ERR₃, corresponding to a hard error signal indicative of a hardware failure and/or a soft error signal indicative of a data transmission error.

In the example considered, the various error signals ERR₁, ..., ERRₘ are provided to the fault collection and error management circuit 120. In response to the error signals ERR₁, ..., ERRₘ, the fault collection and error management circuit 120 may execute various operations.

For example, the fault collection and error management circuit 120 may be configured to generate at least one of:
- an interrupt signal IRQ provided to a processing core 102;
- a reset request signal RST provided to a reset management circuit of the processing system 10;
- a signal ET provided to a terminal EP of the processing system 10, *e.g.,* in order to signal the error to an external circuit; and
- a signal SET used to set the output level of one or more safety critical terminals SCP of the processing system 10.

Specifically, due to an error, the circuits of the processing system 10 may not operate correctly, possibly generating incorrect signals at the pins/pads of the processing system 10. Some of the pins/pads of the processing system 10a may thus be safety-critical pins/pad, *i.e.,* pins/pads which may generate critical situations when driven incorrectly. For example, in Figure 4 is shown schematically a first safety-critical pin SCP₁, which is driven by a processing core 102, and a second safety-critical pin SCP₂, which is driven by a resource/peripheral 106, such as a communication interface or a PWM half-bridge driver.

Generally, each input/output pin/pad of the processing system 10 has usually associated a respective driver circuit IO, which is configured to drive the respective pin/pad as a function of the signal received from the respective block, *e.g.,* the processing system 102 and the hardware resources 106. Generally, between the driver circuits IO and the blocks of the processing system 10a may also be arranged a dedicated logic, such as one or more multiplexers, permitting a configuration of the pin-mapping.

Accordingly, in line with the disclosure of document EP 3 534 261 A1, the driver circuit IO of a safety-critical pins/pads SCP may be configured to set the output level of the respective pin to a given safety state in response to a signal SET. The output level, such as a high-impedance state or a given logic level (high or low), may depend on the specific application needs. Preferably such a "safety state" is compliant to the ISO2626 specification.

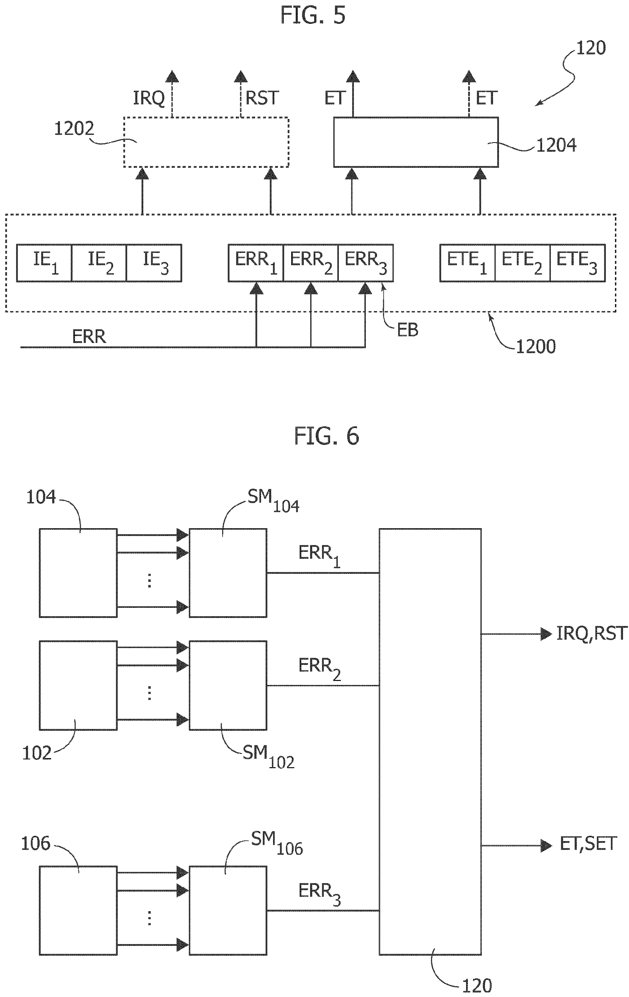

Figure 5 shows a possible implementation of the fault collection and error management circuit 120.

In the example considered, the fault collection and error management circuit 120 comprises a register 1200. Specifically, in the example considered, the register 1200 comprises one or more error bits EB for storing the value of the error signals ERR. For example, considering the exemplary case of three error signals ERR₁..ERR₃, the register 1200 may comprise a corresponding number of error bits EB.

In the example considered, the fault collection and error management circuit 120 comprises an internal reaction circuit 1202. Specifically, the internal reaction circuit 1202 may be configured to generate the interrupt signal IRQ and/or the reset request signal RST as a function of the content of the error bits EB of the register 1200. The error bits EB are purely optional and the external reaction circuit 1202 may generate the interrupt signal IRQ and/or the reset request signal RST also directly as a function of the error signal(s) ERR.

Similarly, the fault collection and error management circuit 120 comprises an external reaction circuit 1204. Specifically, the external reaction circuit 1204 may be configured to generate the error trigger signal ET and/or the signal SET as a function of the content of the error bits EB of the register 1200. Again, the error bits EB are purely optional and the external reaction circuit 1204 may generate the signal ET and/or the signal SET also directly as a function of the error signal(s) ERR.

In general, the behavior of the reaction circuits 1202 and/or 1204 may also be programmable, *e.g*., by setting one or more configuration bits in the register 1200. For example, in the example considered, the register 1200 comprises:
- a respective interrupt enable bit IE for each of the error signals ERR₁..ERR₃, *i.e.,* the interrupt signal IRQ is asserted when also the respective interrupt enable bit IE of an asserted error signal ERR is asserted;
- a respective error trigger enable bit ETE for each of the error signals ERR₁..ERR₃, *i.e.,* the error trigger signal ET is asserted when also the respective error trigger enable bit ETE of an asserted error signal ERR is asserted.

Similarly, the register 1200 may comprise respective reset enable bits for the reset request signal REQ and/or respective enable bits for the safety signal SET.

In order to simplify the data exchange between the processing unit 102 and the registers 1200, the register 1200 may be directly addressable by the processing unit 102, which is schematically shown in Figure 3, where the fault collection and error management circuit 120 is connected to the communication system 114.

Typically, as shown in Figure 6, the hardware error signals ERR are generated by dedicated safety monitor circuits SM. For example, such safety monitor circuits may comprise combinational and/or sequential logic circuits, which monitor the operation of a given circuit. Generally, such safety monitor circuits SM may also comprise analog components, *e.g*., in order to detect an out-of-range condition for an analog signal, such as an internal supply voltage or a signal indicative of the operating temperature of the processing system or a specific circuit of the processing system.

For example, Figure 6 shows a safety monitor circuit SM₁₀₄ configured to monitor one or more signals of the memory 104, a safety monitor circuit SM₁₀₂ configured to monitor one or more signals of a processing core 102 and a safety monitor circuit SM₁₀₆ configured to monitor one or more signals of a resource/peripheral 106. Generally, the safety monitor circuit may also be integrated in the respective circuit.

Accordingly, typically each safety monitor circuit SM monitors one or more signals generated by and/or provided to the associated circuit, and determines whether the behavior of the signal(s) is normal or indicates an error. In general, the operations performed by a given safety monitor circuit SM depend on the associated circuit and may include, *e.g.:*
- a combinational analysis, *e.g*., by combining the signals of the associated circuit in order to determine whether the signal levels are congruent;
- a sequential analysis, e*.g*., by comparing the time evolution of one or more signals with one or more reference signals;
- an analysis of one or more analog signals, *e.g*., by comparing the value of an analog signal with one or more reference values; or
- a combination of the above analyses in order to implement a more complex abnormal behavior analysis.

For example, the safety monitor circuit SM₁₀₄ may comprise an error detection circuit of the memory 104, which calculates (via combinational and optionally sequential logic operations) an error correction code for the data read from the memory and compares (via combinational logic operations) the calculated error correction code with an error correction code read from the memory.

Accordingly, in response to determining an abnormal behavior, the safety monitor circuit SM may assert a respective error signal ERR, which signals the error to the fault collection system 120.

Accordingly, the complete error management system including the fault collection and error management circuit 120 and the various safety monitor circuits SM may be a complex system. For example, such processing systems with a fault collection and error management circuit 120, and examples of safety-monitor circuits SM are disclosed in European Patent Applications EP 4 068 101 A1, EP 4 075 271 A1, EP 4 120 083 A1, EP 4 141 677 A1, EP 4 120 083 A1 and EP 4 254 196 A1, whose contents is incorporated herein by reference for this purpose. Moreover, also documents US 10,459,782 B2, US 2022/0308545 A1, US 11,281,514 B2, CN 110581852 A, CN 104348567 A, US 10,756,823 B2 and CN 108337108 A disclose solutions for detecting errors/faults.

### Summary

The inventors have observed that, e.g., in line with ISO26262, also the operation of the fault collection and error management circuit 120 itself may be safety relevant. For example, a non-reported error, for example because the error signal is stuck or the connection is broken, may create dangerous situation, *e.g.*, in the context of automotive applications.

In view of the above, it is an objective of various embodiments of the present disclosure to provide solutions for monitoring the correct operation of a fault collection and error management circuit of a processing system.

According to one or more embodiments, one or more of the above obj ectives is achieved by means of a processing system having the features specifically set forth in the claims that follow. Embodiments moreover concern a related integrated circuit, device and method.

The scope of protection is defined in the enclosed claims, which are an integral part of the technical teaching of the disclosure provided herein.

As mentioned before, various embodiments of the present disclosure relate to a processing system, *e.g.*, integrated in an integrated circuit, such as a microcontroller. In various embodiments, the processing system comprises a plurality of safety monitoring circuits configured to generate a plurality of error signals by monitoring the operation of one or more circuits of the processing system and a fault collection and error management circuit configured to generate one or more reaction signals as a function of the plurality of error signals, wherein the fault collection and error management circuit comprises a sequential logic circuit configured to be supplied by a first supply voltage and driven by a first clock signal. In various embodiments, the safety monitoring circuits may monitor one or more of the following circuits of the processing system: a processing core, a memory controller, a resource/peripheral, a communication system, a DMA controller, a reset management circuit, a diagnostic circuit and a configuration circuit.

According to a first aspect of the present disclosure, the fault collection and error management circuit comprises a pulse generator circuit configured to generate a trigger signal in response to the first clock signal, wherein the pulse generator circuit is supplied by the first supply voltage. In this case, the processing system comprises also a first monitoring circuit configured to generate a first error signal in response to determining that a time between two consecutive triggers in the trigger signal is greater than a given first maximum time, wherein the first monitoring circuit comprises a sequential logic circuit configured to be supplied by a second supply voltage and driven by a second clock signal.

In various embodiments, the processing system comprises also a second monitoring circuit configured to generate a second error signal in response to determining that a time between two consecutive triggers in the trigger signal is greater than a given second maximum time, wherein the second monitoring circuit comprises a sequential logic circuit configured to be supplied by the second supply voltage and driven by the second clock signal. In this case, the processing system a combinational logic circuit configured to, in response to determining that the first error signal or the second error signal is asserted, assert a third error signal and, in response to determining that the first error signal and the second error signal are de-asserted, de-assert the third error signal.

In various embodiments, the processing system comprises a plurality of (synchronization) flip-flops connected in cascade, wherein a first flip-flop of the plurality of flip-flops is configured to receive the trigger signal and a last flip-flop of the plurality of flip-flops is configured to provide a synchronized trigger signal to the first monitoring circuit and the second monitoring circuit, wherein the flip-flops are driven by the second clock signal. The flip-flops may be supplied by the first supply voltage or the second supply voltage.

In various embodiments, the processing system comprises a communication system, wherein the fault collection and error management circuit comprises a register interface connected to the communication system. In this case, the pulse generator circuit may be configured to set the time between two consecutive triggers in the trigger signal as a function of data stored to the register interface, and/or enable the generation of the triggers in the trigger signal as a function of an enable flag in the register interface.

In various embodiments, each of the first monitoring circuit and the second monitoring circuit comprises a respective register interface coupled to the communication system. In various embodiments, these register interfaces may be connected independently to the communication system or may be connected via a shared interface circuit to the communication system. Each of the first monitoring circuit and the second monitoring circuit may be configured to set the respective first or second maximum time between two consecutive triggers in the trigger signal as a function of the data stored to the respective register interface, and/or enable the monitoring of the triggers in the trigger signal as a function of an enable flag in the respective register interface.

For example, in various embodiments, the processing system may comprise a processing core comprising a microprocessor adapted to send write requests to the communication system in order to program the register interface of the fault collection and error management circuit, the first monitoring circuit and/or the second monitoring circuit. Additionally or alternatively, the processing system may comprise a hardware configuration circuit configured to read configuration data from a non-volatile memory of the processing system and transmit the read configuration data to the register interface of the fault collection and error management circuit, the first monitoring circuit and/or the second monitoring circuit.

According to a second aspect, which may be combined with the first aspect, the processing system comprises a further fault collection and error management circuit configured to generate one or more further reaction signals as a function of the plurality of error signals and a further combinational logic circuit. In various embodiments, the further combinational logic circuit is configured to, in response to determining that the one or more further reaction signals do correspond to the one or more reaction signals, de-assert the fourth error signal and, in response to determining that the one or more further reaction signals do not correspond to the one or more reaction signals, assert the fourth error signal.

In various embodiments, the further fault collection and error management circuit comprises a sequential logic circuit configured to be supplied by the second supply voltage and driven by the second clock signal.

According to a third aspect, which may be combined with the first and/or second aspect, the processing system comprises a test circuit configured to apply modified error signals to the fault collection and error management circuit. In response to determining that the reaction signals have an expected value, the test circuit de-asserts a fifth error signal. Conversely, in response to determining that the reaction signals do not have the expected value, the test circuit asserts the fifth error signal.

In various embodiments, the test circuit comprises a sequential logic circuit configured to be supplied by the second supply voltage and driven by the second clock signal.

In various embodiments, the third error signal, the fourth error signal and/or the fifth error signal are provided to an error terminal of the processing system and/or as reset request signals to one or more reset management circuits of the processing system. In various embodiments, the third error signal, the fourth error signal and/or the fifth error signal is programmable.

In various embodiments, the first and second supply voltages are received via two dedicated terminals, such as pins or pads, of the processing system, *e.g.*, connected to respective external voltage regulators. Alternatively, the processing system 10a may comprise one or more terminals for receiving one or more respective supply voltages, and two (independent and integrated) voltage regulators configured to generate the first and second supply voltages based on the one or more received supply voltages.

In various embodiments, the first and second clock signals are received via two dedicated terminals. Alternatively, the processing system may comprise two clock management circuits, *i.e.,* a first clock management circuit configured to generate the first signal and a second/further clock management circuit configured to generate the second signal. In various embodiments, the first clock management circuit is supplied by the first supply voltage and the second clock management circuit is supplied by the second supply voltage.

### Brief description of the figures

Embodiments of the present disclosure will now be described with reference to the annexed drawings, which are provided purely by way of non-limiting example and in which:
- Figure 1 shows an example of an electronic system comprising a plurality of processing systems;
- Figures 2 and 3 show examples of processing systems;
- Figure 4 shows an example of a processing system comprising a fault collection and error management circuit;
- Figure 5 shows an example of the fault collection and error management circuit of Figure 4;
- Figure 6 shows an example of the connection between a plurality of safety monitoring circuits and the fault collection and error management circuit;
- Figure 7 shows an embodiment of a processing system comprising a fault collection and error management circuit;
- Figures 8 and 9 show embodiments of circuits adapted to verify the operation of a sequential logic circuit of a fault collection and error management circuit;
- Figures 10 and 11 show embodiments of circuits adapted to verify the supply voltage and clock signal of a fault collection and error management circuit;
- Figure 12 shows a further embodiment of a circuit adapted to verify the supply voltage and clock signal of a fault collection and error management circuit; and
- Figure 13 shows an embodiment of a method for operating the circuits of Figure 12.

### Detailed Description

In the following description, numerous specific details are given to provide a thorough understanding of embodiments. The embodiments can be practiced without one or several specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The references provided herein are for convenience only and do not interpret the scope or meaning of the embodiments.

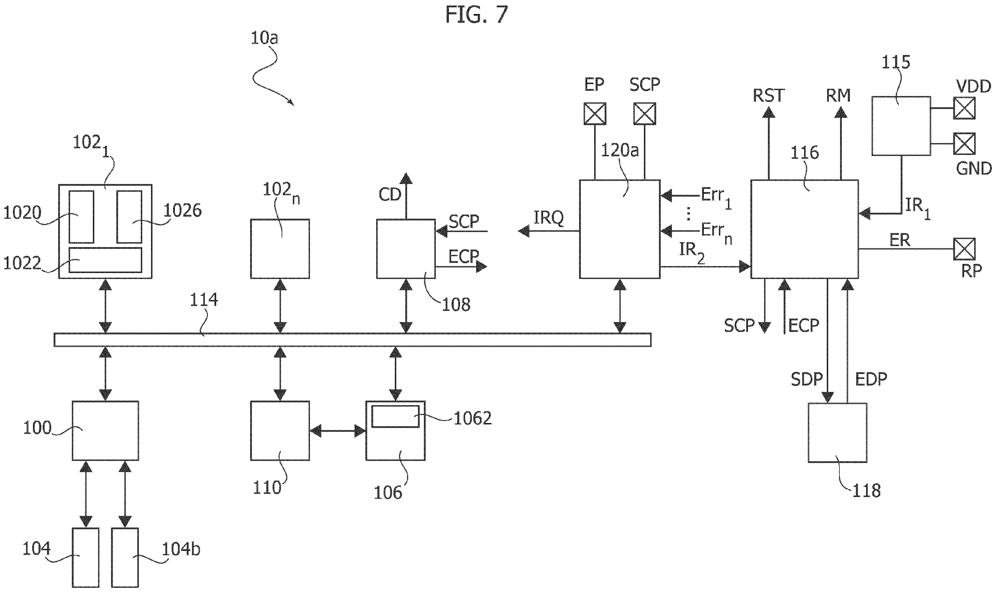

In the following Figures 7 to 13 parts, elements or components which have already been described with reference to Figures 1 to 6 are denoted by the same references previously used in such Figure; the description of such previously described elements will not be repeated in the following in order not to overburden the present detailed description.

Figure 7 shows an embodiment of a processing system 10a according to the present description. In the embodiment considered, the underlying architecture of the processing system 10a corresponds to the processing system described with respect to Figures 1 to 6, and the respective description applies in their entirety. Thus, also in this case, the processing system 10a, such as an integrated circuit, comprises a fault collection and error management circuit 120a and at least one circuit configured to generate an error signal ERR, such as one or more safety monitoring circuits SM monitoring a processing core 102, e.g., comprising a microprocessor 1020, a memory controller 100 configured to be connected to a (internal or external) non-volatile memory 104 and/or a volatile memory 104b, and/or a resource/peripheral 106. In various embodiments, the processing system 10a comprises also a reset management circuit 116.

Moreover, in various embodiments, the processing system may also comprise a hardware configuration circuit 108 and/or a diagnostic circuit 118. For example, in line with the description of European patent application n. EP 4 068 101 A1, configuration data CD may be written into specific areas of the non-volatile memory 104 (or another non-volatile memory of the processing system 10a) and retrieved when the processing system 10a is powered on. For example, the configuration data CD may comprise calibration data used to guarantee that the hardware behavior is uniform, thereby compensating possible production process tolerances. Additionally or alternatively, the configuration data CD may also be used to customize the behavior of various digital circuits.

For example, in various embodiments, once the processing system 10a is switched-on, the reset management circuit 116 may execute a reset phase, where the reset management circuit 116 generates one or more reset signals RST, which are used to perform a reset of the various circuits of the processing system 10a. For example, the processing circuit 10a may comprise for this purpose a power supply monitoring circuit 115 configured to generate a trigger in a reset request signal IR₁, when a supply voltage applied to terminals VDD and GND increases above a given threshold value, i.e., the reset management circuit 116 generates the one or more reset signals RST in response to the reset request signal IR₁. For example, the power supply monitoring circuit 115 may comprise for this purpose a comparator, *e.g.*, a comparator with hysteresis, *i.e.,* a Schmitt trigger. Accordingly, in this way, the processing system 10a is reset when the processing system 10a is switched on. For example, the reset signal(s) RST may correspond to a reset pulse of a given number of clock cycles, provided to the circuits of the processing system 10a. For example, in response to the reset signal(s) RST, the various latches/registers of the processing system 10a (*e.g.,* of the processing core(s) 102 and the resources 106) may be reset.

Next, in case the configuration circuit 108 is used, the reset management circuit 116 may start the configuration phase, *e.g.,* by asserting a signal SCP, which is provided to the configuration circuit 108. For example, in response to the signal SCP, the configuration circuit 108 may read the configuration data CD from the non-volatile memory and distribute the configuration data CD. Generally, the signal SCP is purely optionally because the configuration phase could be started automatically when the reset signal RST is de-asserted.

For example, in various embodiments, in response to the signal SCP, the hardware configuration module 108 may be configured to read the configuration data CD from the non-volatile memory 104 by sending read requests to the memory controller 100 via the communication system 114. Additionally or alternatively, the hardware configuration module 108 may also be connected directly to the memory controller 100 or be configured to read directly the data from the memory 104. Similarly, the hardware configuration module 108 may be configured to send the configuration data CD to the various circuits by sending write requests via the communication system 114. However, the hardware configuration module 108 may also use a separate communication channel for the configuration data CD.

For example, in line with the description of document EP 3 413 194 A1, which is incorporated herein by reference for this purpose, each circuit requiring configuration data may have associated one or more configuration data client circuits, which may also be integrated in the respective circuit. For example, the configuration circuit 108 and the configuration data clients may be connected via the communication system 114 or an additional bus, and each configuration data client may have associated a respective target address. Accordingly, each configuration data client may be configured to receive the configuration data from the module 108, store them into the internal register, *e.g.,* store them into one or more internal flip-flops or latches. The data stored in the register may then be used to generate one or more signals, which influence the behavior of one or more associated circuits. For example, in this case, the configuration data CD may be stored in the form of data packets, wherein each data packet comprises an address of a configuration data client and the respective configuration data to be transmitted to the configuration data client.

At the end of the configuration phase, the configuration circuit 108 may assert a signal ECP in order to indicate that the configuration phase is completed. Accordingly, the reset management circuit 116 may wait that the configuration phase is completed, *e.g.*, until the signal ECP is asserted.

Additionally or alternatively, in case the diagnostic circuit 118 is used, the processing system 10a may be configured to run a diagnostic phase where the processing system 10a executes one or more optional system diagnostic operations, *i.e.,* the processing system 10a executes a Built-In Self-Test (BIST). For example, in the embodiment shown in Figure 7, the processing system 10a comprises a hardware diagnostic circuit 118, which is activated via a signal SDP. Accordingly, in various embodiments, once the signal ECP is asserted, the reset management circuit 116 may assert the signal SDP, thereby starting the diagnostic circuit 118. Next, the reset management circuit 116 may wait until the diagnostic operations have been executed, *i.e.,* the self-test has been completed. For example, the diagnostic circuit 118 may assert a signal EDP once the diagnostic operations have been executed.

In various embodiments, the reset management circuit 116 may be configured to receive also further reset request signals. For example, the reset management circuit 116 may be configured to generate the reset signal(s) RST in response to a reset request signal ER received via a reset terminal RP of the processing system 10a, such as a pad of a respective integrated circuit die or a pin of a respective packaged integrated circuit.

Additionally or alternatively, as described with respect to Figures 3 to 6, the fault collection and error management circuit 120a may generate given internal reactions (*e.g*., a reset or an interrupt) and/or external reactions (driving of the pin EP or setting the safety level of a pin SCP) as a function of the error signals ERR. For example, in the embodiment considered, the error management circuit 120a is configured to generate one or more reset request signals IR₂, which are provided to the reset management circuit 116, *i.e.,* the reset management circuit 116 may be configured to generate the reset signal(s) RST in response to the reset request signal(s) IR₂ received from the fault collection and error management circuit 120a. In various embodiments, the fault collection and error management circuit 120a may also generate one or more interrupt signals IRQ.

For example, as mentioned before, preferably these reactions are programmable for one or more of the error signals ERR. For example, in various embodiments, the fault collection and error management circuit 120a is connected for this purpose to the communication system 114 and comprises a register interface. For example, in order to control the internal reaction, this register interface may comprise for each error signal ERR a respective interrupt enable flag (bits IE in Figure 5) and/or respective reset enable flag. For example, in case a given error signal ERR is asserted, the fault collection and error management circuit 120a may be configured to:
- when the respective interrupt enable flag is set, set an interrupt signal IRQ; and
- when the respective reset enable flag is set, set an internal reset request signal IR₂, which is provided to the reset circuit 116.

In various embodiments, the interrupt signal IRQ is provided to a processing core 102, which may be configured to start a given software error handling routine in response to the interrupt. Generally, the fault collection and error management circuit 120a may also be configured to generate a plurality of interrupt signals IRQ. For example, in this case, the interrupt enable flag may be provided for each error signal. For example, this may be useful in order to handle different errors in a different manner (without having the need to read the error bits EB in order to understand the type of error) and/or in case of multi-core processing systems 10a, wherein one or more interrupt signals IRQ may be provided to each processing core 102.

In various embodiments, the reset management circuit 116 may be programmable, *e.g.,* in order to specify which type of reset (*e.g.,* destructive, functional or simple functional) should be executed in response to the signal IR₂. Additionally or alternatively, in this case, the fault collection and error management circuit 120a may be configured to generate a plurality of reset request signals IR₂, which are associated with given reset types.

Accordingly, in various embodiments, the reset management circuit 116 is configured to executed a reset procedure comprising a reset phase, and optionally a configuration and/or diagnostic phase. Once the reset procedure has been completed, the normal operating phase of the processing system 10a may be started, e.g., by starting the processing core(s) 102, thereby starting a software runtime phase. Generally, while Figure 7 shows an embodiment, where the various reset phases are managed by the reset management circuit 116, these phases could also be managed by a state control circuit of the configuration circuit 108 or another state machine of the processing system 10a. Thus, the reset procedure may be implemented in any suitable manner by the processing system 10a.

As mentioned before, in terms of safety, also the proper functionality of the fault collection and error management circuit 120a should be ensured. In fact, the fault collection and error management circuit 120a is the "central brain" of the whole safety concept. For example, in case the fault collection and error management circuit 120a is not working correctly, an error may remain unhandled, which could have serious consequences, *e.g*., involving the safety of the people impacted by an undetected malfunction within vehicle electronics.

In this respect, the previously cited document EP 4 068 101 A1 discloses solutions for testing the connectivity between the various safety monitoring circuits SM and the fault collection and error management circuit 120a. Moreover, European Patent Application EP 4 254 130 A1, which is incorporated herein by reference for this purpose, discloses solutions for testing the connectivity of the fault collection and error management circuit 120a to the reset management circuit 116, and optionally the operation of the reset management circuit 116. However, the prior-art solutions are unable to detect the correct operation of the fault collection and error management circuit 120a itself.

Therefore, various embodiments of the present disclosure relate to solutions, which ensure that the fault collection and error management circuit 120a works correctly, or at least reduce the risk that the fault collection and error management circuit 120a has a malfunction and may miss to detect and handle an error signaled by the safety monitor circuits SM.

The inventors have observed that a malfunction of the fault collection and error management circuit 120a may derive from various sources, including malfunctions of the combinational and/or sequential logic circuits of the fault collection and error management circuit 120a, the clock signal used by the sequential logic circuits of the fault collection and error management circuit 120a, and the power supply of the combinational and sequential logic circuits of the fault collection and error management circuit 120a. In various embodiments, the solution may also be combined with the circuits of documents EP 4 068 101 A1 and/or EP 4 254 130 A1 for testing the connectivity between the various safety monitoring circuits SM and the fault collection and error management circuit 120a, and/or for testing the connectivity of the fault collection and error management circuit 120a to the reset management circuit 116, and optionally the operation of the reset management circuit 116

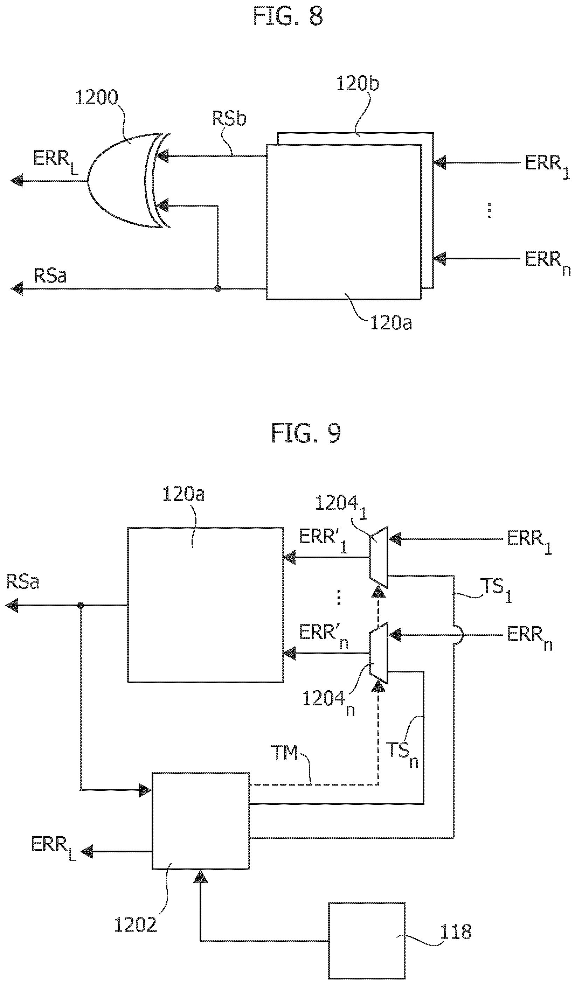

Figure 8 shows a first embodiment of a processing system 10a being configured to verify the correct operation of a fault collection and error management circuit 120a. Specifically, in the embodiment considered, the fault collection and error management circuit 120a receives a plurality of error signals ERR, *e.g.,* ERR₁,...ERRₙ, and generates one or more reaction signals RSa, such as internal and/or external reaction signals, such as one or more of the previous mentioned signals IRQ, IR₂, ET and/or SET. Specifically, for this purpose, the fault collection and error management circuit 120a comprises a sequential logic circuit, *e.g.,* comprising one or more registers 1200 for storing error bits EB and (internal and/or external) enable flags (see e.g., Figure 6) and combinational logic circuits (e.g., 1202 and 1204), for generating the one or more reaction signals RSa as a function of the data stored to the register 1200. Concerning the operation of the fault collection and error management circuit 120a reference can be made to the previous description.

Specifically, in the embodiment considered, the processing system 10a comprises a further fault collection and error management circuit 120b having the same circuit architecture, *i.e.,* the same sequential logic circuit, as the fault collection and error management circuit 120a. Moreover, the fault collection and error management circuit 120b receives the error signals ERR received by the fault collection and error management circuit 120a, e.g., ERR₁,...ERRₙ, and generates one or more reaction signals RSb.

Accordingly, when the circuits 120a and 120b operate correctly, the reaction signals RSa and RSb should correspond. Accordingly, in the embodiment considered, the processing system 10a comprises also a combinational logic circuit 1200, such as an XOR gate, configured to:
- assert an error signal ERR_{L} in response to determining that the signals RSa and RSb do not correspond; and
- de-assert the error signal ERR_{L} in response to determining that the signals RSa and RSb correspond.

Figure 9 shows a second embodiment of a processing system 10a being configured to verify the correct operation of a fault collection and error management circuit 120a. Specifically, in the embodiment considered, the fault collection and error management circuit 120a receives again a plurality of error signals ERR, *e.g.,* ERR₁, ..., ERRₙ, and generates one or more reaction signals RSa, such as internal and/or external reaction signals, such as one or more of the previous mentioned signals IRQ, IR₂, ET and/or SET. Specifically, for this purpose, the fault collection and error management circuit 120a comprises a sequential logic circuit, *e.g.,* comprising one or more registers 1200 for storing error bits EB and (internal and/or external) enable flags (see e.g., Figure 6) and combinational logic circuits (e.g., 1202 and 1204), for generating the one or more reaction signals RSa as a function of the data stored to the register 1200.

Specifically, in the embodiment considered, the processing system 10a comprises a test circuit 1202 configured to test the operation of the fault collection and error management circuit 120a. Specifically, in the embodiment considered, the test circuit 1202 is configured to provide modified error signals ERR', *e.g.,* ERR'₁, ..., ERR'ₙ, to the fault collection and error management circuit 120a and determine whether the signals generated by the fault collection and error management circuit 120a, in particular the one or more reaction signals RSa have an expected value.

For example, in the embodiment considered, the test circuit 1202 has associated (*e.g*., comprises) for each error signal ERR a respective multiplexer 1204, e.g., multiplexer 1204₁, configured to provide for as a respective modified error signal ERR', *e.g.,* the modified error signal ERR'₁, either the respective (original) error signal ERR, *e.g.,* the error signal ERR₁, *e.g.,* when a respective test mode signal TM is de-asserted, or a respective test signal TS, *e.g.,* a test signal TS₁, *e.g*., when a respective test mode signal TM is asserted.

Accordingly, in various embodiments, the test circuit 1202 may be configured to assert the test mode signal TS, provide one or more patterns of test signals TS₁, ..., TSₙ, to the fault collection and error management circuit 120a and determine whether the one or more reaction signals RSa generated by the fault collection and error management circuit 120a have respective expected values. For example, in response to determining that at least one of the one or more reaction signals generated by the fault collection and error management circuit 120a does not have the respective expected value, the test circuit 1202 may assert an error signal ERR_{L}.

For example, in various embodiments, the above test operation of the test circuit 1202 may be executed during the self-test operation of the processing system 10a. For example, this is schematically shown in Figure 9, wherein the test circuit 1202 starts the test sequency in response to a signal received from the diagnostic circuit 118. For example, in this case may be omitted also the test mode signal TM, because the error signals ERR should not be asserted during the diagnostic phase. For example, in this case, the multiplexers 1204₁, ..., 1204ₙ may be replaced with other combinational logic circuits, such as OR or XOR gates, which permit to assert a given signal ERR' as a function of a respective test signal TS.

In various embodiments, the solutions shown in Figures 8 and 9 may also be combined. Accordingly, in general, the processing system 10a comprises a circuit for testing the combinational and/or sequential logic circuit of the fault collection and error management circuit 120a, *e.g.,* via a redundant fault collection and error management circuit 120b, and/or a dedicates test circuit 1202.

However, the embodiments shown in Figures 8 and 9 do not ensure that the clock signal and the power supply used by the fault collection and error management circuit 120a also operate correctly.

The inventors have observed that a protection of a clock signal can be implemented with a clock monitor unit, used to measure, at a regular time interval, the clock frequency. For example, such a solution is disclosed in US 11,281,514 B2, which is incorporated herein by reference for this purpose. Moreover, a protection of the supply voltage can be implemented with dedicated voltage monitor circuit, *e.g.,* the supply voltage monitoring circuit 115 shown in Figure 7.

Such solutions are usually enough robust and widely used in nowadays micro-controllers. However, improved solutions may be useful to reduce the risk of interference between the various circuits, *e.g.*, in case of a local power loss or a local clock signal failure, which could just influence the fault collection and error management circuit 120a, resulting in an undetected failure.

In this respect, the solutions shown in Figures 8 and 9 have also the disadvantage that a power failure can impact the functionality of both the fault collection and error management circuit 120a and the circuits (e.g., 120b and/or 1202) used to monitor the operation of the fault collection and error management circuit 120a. Moreover, a voltage monitor (e.g., 115) may detect a power malfunction, but it should be ensured that the respective error trigger is properly managed by the fault collection and error management circuit 120a. The same problem exists for the clock signal used by the fault collection and error management circuit 120a, wherein the clock monitoring functionality should not depend on the same clock being monitored.

Accordingly, in the following will be described different solutions.

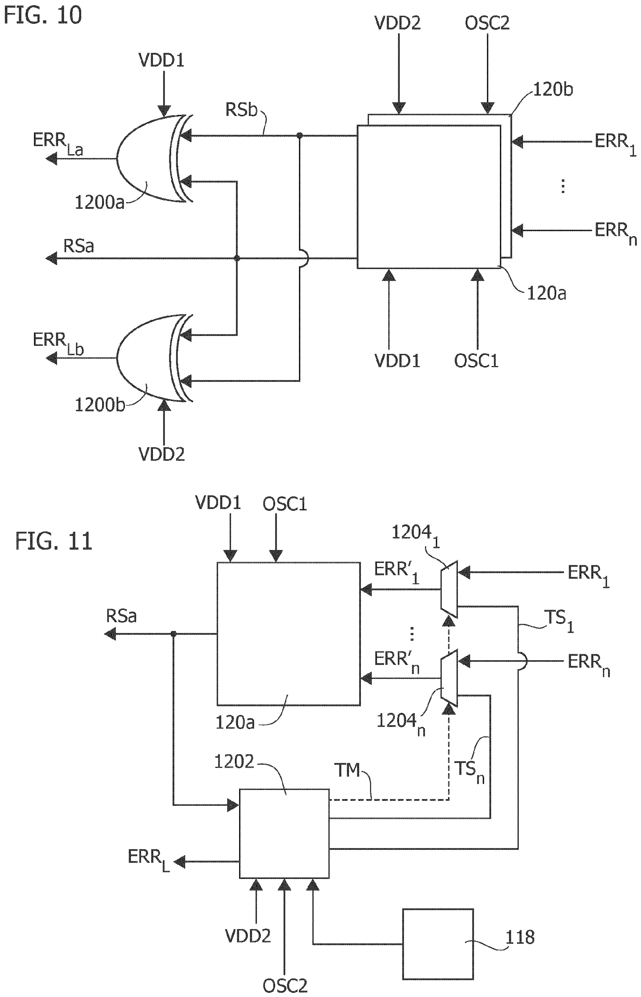

Specifically, in various embodiments, as shown in Figure 10, in order to verify also the clock signal OSC1 and the supply voltage VDD1 of the fault collection and error management circuit 120a, the further fault collection and error management circuit 120b is driven by a further clock signal OSC2 and receives a further supply voltage VDD2.

In various embodiments, the supply voltages VDD1 and VDD2 are received via two dedicated terminals, such as pins or pads, of the processing system 10a, e.g., connected to respective external voltage regulators. Alternatively, the processing system 10a may comprise one or more terminals for receiving one or more respective supply voltages, and two (independent) voltage regulators configured to generate the supply voltages VDD1 and VDD2 based on the one or more received supply voltages.

In various embodiments, the clock signals OSC1 and OSC2 are received via two dedicated terminals. Alternatively, the processing system 10a may comprise a first clock management circuit 130a configured to generate the signal OSC1, e.g., comprising an oscillator generating the clock signal OSC1 or a Phase-locked loop (PLL) generating the clock signal OSC1 based on a clock signal received via a terminal of the processing system 10a, and a second clock management circuit 130b configured to generate the signal OSC2, e.g., comprising an oscillator generating the clock signal OSC2 or a PLL generating the clock signal OSC2 based on a clock signal received via a terminal of the processing system 10a.

In various embodiments, the first clock management circuit 130a is supplied by the first supply voltage VDD1 and the second clock management circuit 130b is supplied by the second supply voltage VDD2.

Accordingly, in this way, the fault collection and error management circuit 120b is completely independent from the fault collection and error management circuit 120a. Moreover, in order to verify the generation of the reaction signals RSa and RSb, the processing system 10a may comprise a first logic gate 1200a, such as an XOR gate, configured to generate a first error signal ERR_{La} when the signals RSa and RSb do not correspond, and a second logic gate 1200b, such as an XOR gate, configured to generate a second error signal ERR_{La} when the signals RSa and RSb do not correspond, wherein the first logic gate 1200a is supplied with the voltage VDD1 and the second logic gate 1200b is supplied with the voltage VDD2.

Similarly, as shown in Figure 11, in various embodiments, the test circuit 1202 is driven with a further clock signal OSC2 and supplied with a further supply voltage VDD2. In general, the combinational logic circuits 1204 may be supplied via the voltage VDD1 or VDD2.

However, while verifying implicitly also the clock signal OSC1 and supply voltage VDD1 of the fault collection and error management circuit 120a, these embodiments have several disadvantages.

Specifically, the solutions shown in Figures 10 and 11 are usually sufficient in order to detect defects in the logic circuits of the fault collection and error management circuit 120a, which usually change rarely. However, these solutions are unable to detect the instant when the clock signal OSC1 or the supply voltage VDD is missing. For example, the solution shown in Figure 10 may detect such a malfunction of the fault collection and error management circuit 120a only once an error signal ERR is asserted. However, in this case, the reaction of the fault collection and error management circuit 120a may not be ensured anymore. Conversely, the solution shown in Figure 11 is usually just used during a diagnostic phase and is thus unable to detect malfunctions of the fault collection and error management circuit 120a occurring during the normal operating phase of the processing system.

Moreover, usually it is advisable to place circuits belonging to different power domains in different areas within the integrated circuit, which implies that a significant number of signals have to be exchanged between the two power domains. Moreover, in case of circuits operating with different clock signals, usually a synchronization circuit is required for each signal to be synchronized, thereby increasing the complexity of the circuit.

Accordingly, in the following will be described an embodiment, which permits to detect almost instantaneously a failure of the clock signal OSC1 or the supply voltage VDD1. Moreover, the solution permits that only a reduced number of signals, and in various embodiments only a single signal, has to be exchanged between the different power and clock domains.

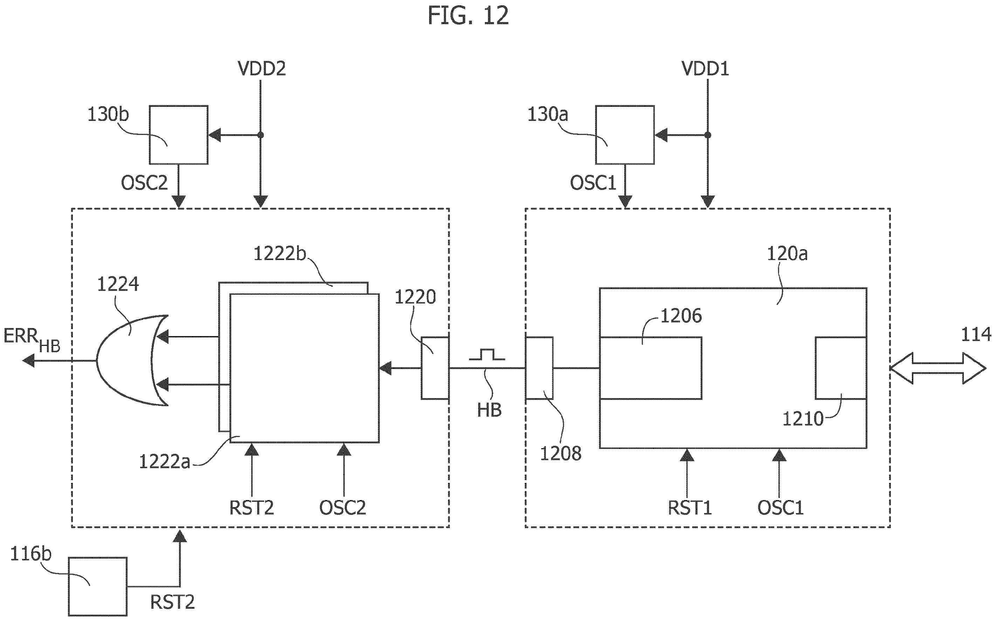

Specifically, in the embodiment shown in Figure 12, the fault collection and error management circuit 120a has associated (*e.g*., comprises) a pulse generator circuit 1206, which is driven with the clock signal OSC1 and supplied with the voltage VDD1, which are also used by the fault collection and error management circuit 120a to generate the one or more reaction signals RSa as a function of the error signals ERR. In general, while Figure 12 shows just the fault collection and error management circuit 120a, the processing system 10a may also comprise the fault collection and error management circuit 120b and/or the test circuit 1202 for testing the logic circuits of the fault collection and error management circuit 120a. In various embodiments, the fault collection and error management circuit 120b and/or the test circuit 1202 may receive the voltage VDD1 or VDD2, and may be driven via the clock signal OSC1 or OSC2. For example, in various embodiments, the fault collection and error management circuit 120b and/or the test circuit 1202 receive the clock signal OSC1 and the voltage VDD1.

For example, in various embodiments, the pulse generator circuit 1206 may be started automatically when the processing system 10a is switched on, *e.g.,* in response to a reset signal generated by the reset management circuit 116. Conversely, in other embodiments the pulse generator circuit 1206 is switched off after a (*e.g.,* power on) reset and the pulse generator circuit 1206 is enabled in response to given events. For example, in various embodiments, the fault collection and error management circuit 120a may comprise a register interfaces 1210, *e.g.,* connected to the communication system 114. For example, such a register interface 1210 may be used to store the interrupt or reset enable flags or in general the routing data for generating the one or more (internal and/or external) reaction signals RSa as a function of the error signals ERR.

In this case, the pulse generator circuit 1206 may be configured to start the pulse generation in response to determining that an enable flag of the register interface 1210 is asserted. For example, in this way the pulse generator circuit 1206 may be enabled by:
- storing given configuration data CD, *e.g*., comprising address data associated with the register interface 1210 and the enable flag for the pulse generator circuit 1206, to a non-volatile memory of the processing system 10a, *e.g.,* the memory 104, whereby the hardware configuration circuit 108 reads the configuration data CD from the non-volatile memory and stores the given configuration data CD to the register interface 1210, thereby asserting the enable flag and enabling the pulse generator circuit 1210; and/or
- sending via a processing core 102 a write request to the register interface 1210 in order to assert the enable flag.

In various embodiments, once enabled, the pulse generator circuit 1206 is configured to generate a pulsed signal HB in response to the clock signal OSC1. For example, the pulse generator circuit 1206 may be implemented with a counter circuit configured to increase (or decrease) a count value in response to the clock signal OSC1 and assert the signal HB when the count value corresponds to one or more reference values. For example, the pulse generator circuit 1206 may implement a frequency scaling circuit of the clock signal OSC1 or a trigger generator circuit. In various embodiments, the time between two consecutive triggers in the signal HB is configurable, *e.g*., programmable.

The pulse generator signal 1206 provides thus a signal HB, which varies periodically when the clock signal OSC1 is operating correctly. For this reason, the pulsed signal HB is also identified as heartbeat signal in the following.

In various embodiments, the heartbeat signal HB is provided to a monitoring circuit 1222a. Specifically, in various embodiments, the monitoring circuit 1222a is driven with the further clock signal OSC2 and supplied with the further supply voltage VDD2. Accordingly, the monitoring circuit 1222a is in a different clock and power domain, and may be located in a different area of the integrated circuit with respect to the fault collection and error management circuit 120a. As mentioned before, the clock signal OSC2 may be generated by a further (internal or external) clock management circuit 130b and the supply voltage VDD2 may be provided by a further (internal or external) voltage regulator.

In various embodiments, in order to transmit the heartbeat signal HB from the pulse generator circuit 1206 to the monitoring circuit 1222a, the processing system 10a may comprise a synchronization circuit. For example, in various embodiments, the synchronization circuit may comprise a plurality of flip-flops 1220, such as two flip-flops, connected in cascade, wherein the flip-flops 1220 are driven via the clock signal OSC2, and wherein the first flip-flop 1220 receives the heartbeat signal HB and the last flip-flop HB provides a synchronized heartbeat signal to the monitoring circuit 1222a. In various embodiments, the synchronization circuit may also comprise a flip-flop 1208 or several flip-flops connected in cascaded, wherein the flip-flop(s) 1208 are driven via the clock signal OSC1, and wherein the flip-flop 1208 or the first flip-flop receives the signal at the output of the pulse generator circuit 1206, and the flip-flop 1208 or the last flip-flop provides the heartbeat signal HB. In general, the flip-flop 1208 is purely optional because the pulse generator circuit 1206 is already a sequential logic circuit comprising a plurality of flip-flops.

In various embodiments, the flip-flops 1208 and 1220 are supplied with the voltage VDD1 and/or VDD2. For example, in various embodiments, the flip-flops 1220 are arranged within the integrated circuit near the monitoring circuit 1222a and the flip-flop(s) 1208 are arranged within the integrated circuit near the pulse generator circuit 1206. Accordingly, the flip-flops 1220 may be supplied with the voltage VDD2 and the flip-flop(s) 1208 may be supplied with the voltage VDD1.

In various embodiments, the monitoring circuit 1222a is configured to detect whether the heartbeat signal HB (or preferably the synchronized heartbeat signal at the output of the flip-flops 1220) varies periodically. For example, the monitoring circuit 1222a may be implemented with a watchdog timer configured to generate an error signal when the time between two consecutive triggers in the heartbeat signal HB is greater than a given maximum time. Additionally or alternatively, a monitoring circuit 1222a may be configured to generate an error signal when the time between two consecutive triggers in the heartbeat signal HB is not between a lower threshold and an upper threshold.

In various embodiments, the maximum time, or the lower threshold and the upper threshold may be programmable. For example, for this purpose, the monitoring circuit 1222a may comprise a register interface, e.g., connected to the communication system 114. Accordingly, also this register interface may be programmed via the hardware configuration circuit 108 (when used) and/or via software instructions executed by a processing core 102.

Additional or alternatively, in various embodiments, the register interface of the monitoring circuit 1222a may also be used to enable the monitoring circuit 1222a. For example, in this way, the pulse generator circuit may be enabled (via the configuration data CD or via a processing core 102) and then the monitoring circuit 1222a may be enabled via the configuration data CD or via a processing core 102).

Accordingly, in various embodiments, the pulse generator circuit 1206 and the monitoring circuit 1222a are implemented with sequential logic circuits, which should be reset during the reset phase of the processing system 10a. In various embodiments, the reset management circuit 116 may be configured to generate a first reset signal RST1 for the fault collection and error management circuit 120a and the pulse generator circuit 1206, and a second reset signal RST2 for the monitoring circuit 1222a. Conversely, in other embodiments, the processing system 10b may comprise the reset management circuit 116 configured to generate the reset RST1 and a further reset management circuit 116b configured to generate the reset signal RST2. Specifically, in this case, the further reset management circuit 116b may be supplied by the voltage VDD2 and driven by the clock signal OSC2. In general, the further reset management circuit 116b may receive the reset request signals provided to the further reset management circuit 116, a subset of these reset request signals and/or at least in part different reset request signals.

In various embodiments, the processing system 10a comprises a further monitoring circuit 1222b having the same circuit architecture, *i.e.,* the same sequential logic circuit, as the monitoring circuit 1222a, wherein also the monitoring circuit 1222b is driven by the clock signal OSC2 and supplied by the voltage VDD2. Moreover, also the monitoring circuit 1222b received the heartbeat signal HB (preferably the synchronized heartbeat signal at the output of the flip-flops 1220) received by the monitoring circuit 1222a generates a further error signal.

In various embodiments, also the monitoring circuit 1222b comprises a register interface, e.g., connected to the communication system. In various embodiments, this register interface may have a separate address with respect to the register interface of the monitoring circuit 1222a. Conversely, in other embodiments, the register interfaces of the monitoring circuits 1222a and 1222b are connected to the communication system 114 via an (shared) interface circuit configure to:
- in response to receiving a write request, store the received data to the register interfaces of both monitoring circuits 1222a and 1222b; and
- when read requests are supported, in response to receiving a read request, provide the data stored to the register interface of the monitoring circuit 1222a.

Accordingly, in this case, the register interfaces of the monitoring circuits 1222a and 1222b have associated the same address(es). In various embodiments, in response to receiving a read request, the interface circuit may also compare the data stored to register interfaces of the monitoring circuits 1222a and 1222b. In response to determining that the data do not correspond, the interface circuit may generate a further error signal and/or may assert a flag in the returned data.

Accordingly, when the circuits 1222a and 1222b operate correctly, the respective error signals should correspond. Accordingly, in the embodiment considered, the processing system 10a comprises also a combinational logic circuit 1224, such as an OR gate, configured to:
- assert an error signal ERR_{HB} in response to determining that at least one of the error signals provided by the circuits 1222a and 1222b is asserted; and
- de-assert the error signal ERR_{HB} in response to determining that the error signals provided by the circuits 1222a and 1222b are de-asserted.

In various embodiments, also the combinational logic circuit 1224 is supplied by the voltage VDD2.

Accordingly, the error signals ERR_{L} and/and ERR_{HB} are asserted when the fault collection and error management circuit 120a is not working correctly. Accordingly, it may be useless to provide these signals again to the fault collection and error management circuit 120a. However, these signals may be provided as reset request signals directly to the reset management circuit 116 (see Figure 7) and/or the reset management circuit 116b (see Figure 12), and/or provided to one or more error pins EP of the processing system 10a (see Figure 4). In various embodiments, the routing of the error signals ERR_{L} and/and ERR_{HB} may also be configurable, *e.g*., programmable.

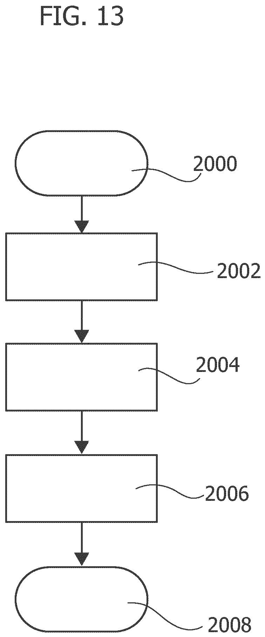

Figure 13 shows an embodiment of a method of operating the processing system 10a.

After a start step 2000, the fault collection and error management circuit 120a is configured at a step 2002. For example, this may include that the period between the triggers in the heartbeat signal HB is configured for the pulse generator circuit 1206 and the pulse generator circuit 1206 is enabled.

In various embodiments, at a step 2004, the routing of the error signals ERR_{L} and ERR_{HB} may be configured.

At a step 2006, the monitoring circuits 1222a and 1222b are configured and the method ends at a stop step 2008. For example, this may include that the maximum time, or the lower threshold and the upper threshold, for the comparison with the time between two consecutive triggers in the heartbeat signal HB are configured and the monitoring circuits 1222a and 1222b are enabled. Accordingly, after the step 2006, the monitoring circuits 1222a and 1222b autonomously monitor that the pulse generator circuit 1206 of the fault collection and error management circuit 120a is alive and generates correctly the pulse stream at the expected rate.

As described in the foregoing, the above steps may be implemented via configuration data CD and/or software instructions executed by a processing core 102. In various embodiments, the configuration parameters may also be set before the pulse generator circuit 1206 and the monitoring circuits 1222a and 1222b are enabled. For example, in various embodiments, the processing system 10a may have stored configuration data CD in order to configure (during the configuration phase executed by the hardware configuration circuit 108) the configuration parameters, in particular:
- when being programmable, the period between the triggers of the pulse generator circuit 1206,
- when being programmable, the maximum time, or the lower threshold and the upper threshold, of the monitoring circuits 1222a and 1222b, and
- when being programmable, the routing of the error signals ERR_{L} and/or ERR_{HB}, *e.g.,* to the reset management circuit 116 and/or one or more error pins EP.

Conversely, the processing system 10a may have stored software instructed, which when executed by a processing core 102, cause the processing core 102 to enable the pulse generator circuit 1206 and then the monitoring circuits 1222a and 1222b. In other embodiments, the software instructions may also be used to program the configuration parameters.

In various embodiments, the processing system 10a may be configured, such that the pulse generator circuit 1206 and the monitoring circuits 1222a and 1222b can just be enabled, but not be disabled via the respective register interfaces, i.e., once enabled, the monitoring function cannot be disabled again and, e.g., continuous until a new reset (or switch-off) of the processing system 10a.

Accordingly, in various embodiments, the processing system 10a comprises a fault collection and error management circuit 120a and at least one circuit configured to monitor the operation of the fault collection and error management circuit 120a. In this respect, the redundant fault collection and error management circuit 120b, the test circuit 1202 and the heartbeat monitoring circuits 1222a and 1222b may be used separately, or in any suitable combination. Specifically, in various embodiments, these circuits may be driven by a further (independent) clock signal OSC2 and supplied by a further (independent) supply voltage VDD2.

Of course, without prejudice to the principle of the invention, the details of construction and the embodiments may vary widely with respect to what has been described and illustrated herein purely by way of example, without thereby departing from the scope of the present invention, as defined by the ensuing claims.

## Claims

1. A processing system (10a) comprising:
- a plurality of safety monitoring circuits (SM) configured to generate a plurality of error signals (ERR) by monitoring the operation of one or more circuits (100, 102, 104, 106, 108, 110) of said processing system (10a);
- a fault collection and error management circuit (120a) configured to generate one or more reaction signals (RSa; IRQ, IR2, ET, SET) as a function of said plurality of error signals (ERR), wherein said fault collection and error management circuit (120a) comprises a sequential logic circuit configured to be supplied by a first supply voltage (VDD1) and driven by a first clock signal (OSC1);
wherein said fault collection and error management circuit (120a) comprises a pulse generator circuit (1206) configured to generate a trigger signal (HB) in response to said first clock signal (OSC1), wherein said pulse generator circuit (1206) is supplied by said first supply voltage (VDD1);
wherein said processing system (10a) comprises:
- a first monitoring circuit (1222a) configured to generate a first error signal in response to determining that a time between two consecutive triggers in said trigger signal (HB) is greater than a given first maximum time, wherein said first monitoring circuit (1222a) comprises a sequential logic circuit configured to be supplied by a second supply voltage (VDD2) and driven by a second clock signal (OSC2);
- a second monitoring circuit (1222b) configured to generate a second error signal in response to determining that a time between two consecutive triggers in said trigger signal (HB) is greater than a given second maximum time, wherein said second monitoring circuit (1222b) comprises a sequential logic circuit configured to be supplied by said second supply voltage (VDD2) and driven by said second clock signal (OSC2);
- a combinational logic circuit (1224) configured to:
- in response to determining that said first error signal or said second error signal is asserted, assert a third error signal (ERR_{HB}), and
- in response to determining that said first error signal and said second error signal are de-asserted, de-assert said third error signal (ERR_{HB}).

2. The processing system (10a) according to Claim 1, wherein said processing system (10a) comprises:
- a plurality of flip-flops (1220) connected in cascade, wherein a first flip-flop of said plurality of flip-flops (1220) is configured to receive said trigger signal (HB) and a last flip-flop of said plurality of flip-flops (1220) is configured to provide a synchronized trigger signal to said first monitoring circuit (1222a) and said second monitoring circuit (1222b), wherein said plurality of flip-flops (1220) are driven by said second clock signal (OSC2), and supplied by said first supply voltage (VDD1) or said second supply voltage (VDD2).

3. The processing system (10a) according to Claim 1 or Claim 2, wherein said processing system (10a) comprises a communication system (114), wherein said fault collection and error management circuit (120a) comprises a register interface (1210) connected to said communication system (114), wherein said pulse generator circuit (1206) is configured to:
- set the time between two consecutive triggers in said trigger signal (HB) as a function of data stored to said register interface (1210), and/or
- enable the generation of the triggers in said trigger signal (HB) as a function of an enable flag in said register interface (1210).

4. The processing system (10a) according to any of the previous claims, wherein said processing system (10a) comprises a communication system (114), wherein each of said first monitoring circuit (1222a) and said second monitoring circuit (1222b) comprises a respective register interface coupled to said communication system (114), wherein each of said first monitoring circuit (1222a) and said second monitoring circuit (1222b) is configured to:
- set the respective first or second maximum time between two consecutive triggers in said trigger signal (HB) as a function of the data stored to the respective register interface, and/or
- enable the monitoring of the triggers in said trigger signal (HB) as a function of an enable flag in the respective register interface.

5. The processing system (10a) according to Claim 3 and/or Claim 4, wherein said processing system comprises at least one of:
- a processing core (102) comprising a microprocessor (1020) adapted to send write requests to said communication system in order to program the register interface of said fault collection and error management circuit (120a), said first monitoring circuit (1222a) and/or said second monitoring circuit (1222b); and/or
- a hardware configuration circuit configured to read configuration data (CD) from a non-volatile memory (104) of said processing system (10a) and transmit said read configuration data to the register interface of said fault collection and error management circuit (120a), said first monitoring circuit (1222a) and/or said second monitoring circuit (1222b).

6. The processing system (10a) according to any of the previous claims, wherein said processing system (10a) comprises:
- a circuit (120b; 1202) configured to assert a one or more error signals (ERR_{L}) in response to determining that said sequential logic circuit of said fault collection and error management circuit does not operate correctly (120a).

7. The processing system (10a) according to Claim 6, wherein said circuit (120b; 1202) comprises:
- a further fault collection and error management circuit (120b) configured to generate one or more further reaction signals (RSb) as a function of said plurality of error signals (ERR); and
- a further combinational logic circuit (1200) configured to:
- in response to determining that said one or more further reaction signals (RSb) do correspond to said one or more reaction signals (RSa), de-assert a fourth error signal (ERR_{L}), and
- in response to determining that said one or more further reaction signals (RSb) do not correspond to said one or more reaction signals (RSa), assert said fourth error signal (ERR_{L}).

8. The processing system (10a) according to Claim 6 or Claim 7, wherein said circuit (120b; 1202) comprises:
- a test circuit (1202, 1204) configured to:
- apply modified error signals (ERR') to said fault collection and error management circuit (120a),
- in response to determining that said reaction signals (RSa) have an expected value, de-assert a fifth error signal (ERR_{L}); and
- in response to determining that said reaction signals (RSa) do not have said expected value, assert said fifth error signal (ERR_{L}).

9. The processing system (10a) according to any of the previous claims, wherein said third error signal (ERR_{HB}) and optionally said fourth error signal (ERR_{L}) are provided to an error terminal (EP) of said processing system (10a) and/or as reset request signals to a reset management circuit (116; 116b) of said processing system (10a).

10. The processing system (10a) according to Claim 9, wherein the routing of said third error signal (ERR_{HB}) and optionally said fourth error signal (ERR_{L}) is programmable.

11. An integrated circuit comprising a processing system (10a) according to any of the previous claims.

12. A device, such as a vehicle, comprising a plurality of processing systems (10a) according to any of the previous claims 1 to 10, wherein said processing systems (10a) are connected via a further communication system (20).

13. A method of operating a processing system (10a) according to any of the previous Claims 1 to 10, comprising the steps of:
- starting (2002) said pulse generator circuit (1206); and
- starting (2006) said first monitoring circuit (1222a) and said second monitoring circuit (1222b).
